# EUROPÄISCHE PATENTSCHRIFT

(11) **EP 1 456 870 B1**
(45) Veröffentlichungstag und Bekanntmachung des Hinweises auf die Patenterteilung: **20.07.2005**
(21) Anmeldenummer: 02791623.8
(22) Anmeldetag: 10.12.2002
(51) Int. Cl.: H01L 21/033, H01L 21/308, G03F 1/00, H01L 21/3213, H01L 21/311, H01L 21/265, B81C 1/00

(54) **RESISTLOSES LITHOGRAPHIEVERFAHREN ZUR HERSTELLUNG FEINER STRUKTUREN**
RESISTLESS LITHOGRAPHY METHOD FOR PRODUCING FINE STRUCTURES
PROCEDE DE LITHOGRAPHIE SANS RESIST POUR LA REALISATION DE STRUCTURES FINES

(30) Priorität: 21.12.2001 DE 10163346
(43) Veröffentlichungstag der Anmeldung: 15.09.2004
(73) Patentinhaber: Infineon Technologies AG, 81669 München (DE)
(72) Erfinder: TEWS, Helmut, 81549 München (DE); FEHLHABER, Rodger, 80687 München (DE)
(74) Vertreter: Karl, Frank
(86) Internationale Anmeldenummer: PCT/DE2002/004524
(87) Internationale Veröffentlichungsnummer: WO 2003/056611

(56) Entgegenhaltungen:
- EP-A- 0 321 144
- EP-A- 0 363 099
- US-A- 4 450 041
- RENSCH D B ET AL: "SUBMICROMETER FET GATE FABRICATION USING RESISTLESS AND FOCUSED ION BEAM TECHNIQUES" JOURNAL OF VACUUM SCIENCE AND TECHNOLOGY: PART B, AMERICAN INSTITUTE OF PHYSICS. NEW YORK, US, Bd. 3, Nr. 1, Januar 1985 (1985-01), Seiten 286-289, XP000810529 ISSN: 0734-211X
- RENNON S ET AL: "Nanoscale patterning by focused ion beam enhanced etching for optoelectronic device fabrication" MICROELECTRONIC ENGINEERING, ELSEVIER PUBLISHERS BV., AMSTERDAM, NL, Bd. 57-58, September 2001 (2001-09), Seiten 891-896, XP004302358 ISSN: 0167-9317
- BRUGGER J ET AL: "Silicon Micro/Nanomechanical Device Fabrication Based on Focused Ion Beam Surface Modification and KOH Etching" MICROELECTRONIC ENGINEERING, ELSEVIER PUBLISHERS BV., AMSTERDAM, NL, Bd. 35, Nr. 1, 1. Februar 1997 (1997-02-01), Seiten 401-404, XP004054087 ISSN: 0167-9317
- PATENT ABSTRACTS OF JAPAN vol. 014, no. 187 (E-0917), 16. April 1990 (1990-04-16) & JP 02 034922 A (FUJITSU LTD), 5. Februar 1990 (1990-02-05)

## Beschreibung

Die vorliegende Erfindung bezieht sich auf ein resistloses Lithographieverfahren zur Herstellung feiner Strukturen und insbesondere auf ein resistloses Lithographieverfahren zur Herstellung von sub-100 nm Strukturen in einem Trägermaterial oder Halbleitermaterial.

Bei der Entwicklung von geeigneten Lithographieverfahren zur Herstellung sehr feiner Strukturen in einem sub-100 nm Bereich ergeben sich außerordentlich große Probleme, die insbesondere aus der sogenannten Resistchemie, der Maskenherstellung und der Komplexität des Lithographiesystems resultieren.

Bei der Weiterentwicklung der optischen Lithographie zur Herstellung von sehr feinen Strukturen im Bereich kleiner 100 nm wurde die sogenannte 157nm-Lithographie erreicht. Diese Lithographieverfahren benötigen hierbei neuartige ResistMaterialien, wobei trotz intensivster Bemühungen bisher kein Resist gefunden wurde, der vollständig die technischen Anforderungen hinsichtlich derartig kleiner Strukturen erfüllt. Darüber hinaus sind neben diesen neuen Materialien auch neue Verfahren zur Maskenherstellung notwendig, wobei deren Entwicklung wiederum sehr kostenintensiv ist. Es ergeben sich daher sehr kostenintensive und schwer handhabbare Lithographiesysteme.

Als Alternative zu derartigen herkömmlichen optischen Lithographieverfahren wurde daher beispielsweise ein maskenloses Lithographieverfahren, wie beispielsweise ein direktes Elektronenstrahl-Schreibverfahren (electron beam direct write lithography, EBDW) eingeführt, wobei wiederum ein geeigneter Resist benötigt wird. Unter einem Resist versteht man hierbei eine im Wesentlichen organische Belichtungsschicht, die vorzugsweise ein Polymer aufweist.

Andere Alternativen zur Belichtung sind beispielsweise Ionenprojektions-Lithographieverfahren (ion projection lithography, IPL), wobei sogenannte Stencil-Masken zum Abbilden der Strukturen auf einem speziellen Resistmaterial verwendet werden. Insbesondere die Herstellung eines geeigneten Resistmaterials beschränkt jedoch zunehmend die Realisierung von immer feiner werdenden Strukturen.

Aus der Druckschrift EP-A-0 321 144 ist ein resistloses Lithographieverfahren zur Herstellung feiner Strukturen in einem Trägermaterial bekannt, wobei nach dem Vorbereiten des Trägermaterials zunächst eine Halbleiter-Maskenschicht auf dem Trägermaterial ausgebildet und eine selektive Ionenimplantation zum Dotieren von ausgewählten Bereichen der Halbleiter-Maskenschicht durchgeführt wird. Anschließend erfolgt zum Ausbilden einer Halbleitermaske ein nasschemisches Entfernen der dotierten oder nicht-dotierten Bereiche der Halbleiter-Maskenschicht, wobei abschließend das Trägermaterial unter Verwendung der strukturierten Halbleitermaske strukturiert wird.

Aus der Druckschrift JP 63051641 A1 ist ein Strukturierungsverfahren bekannt, wobei in einer polykristallinen Si-Halbleiterschicht mittels Ionenimplantation Sauerstoff eingebracht wird und anschließend zur Strukturierung eine Laser-Ätzung erfolgt. Feine Strukturen im sub-100 nm-Bereich können dadurch jedoch nur unzureichend ausgebildet werden.

Ferner ist aus der Druckschrift US 5,918,143 ein resistloses Lithographieverfahren zur Herstellung feiner Strukturen im sub-100 nm-Bereich bekannt, wobei mittels eines fokussierten Elektronenstrahls eine spezielle Metall/Halbleiterschicht Belichtet wird und anschließend eine Strukturierung erfolgt. Nachteilig ist hierbei jedoch der hohe Zeitaufwand sowie die geringe Kompatibilität mit Standard-Herstellungsverfahren.

Der Erfindung liegt daher die Aufgabe zu Grunde ein resistloses Lithographieverfahren zur Herstellung feiner Strukturen zu schaffen, welches einfach und kostengünstig zu realisieren ist.

Erfindungsgemäß wird diese Aufgabe mit den Maßnahmen des Patentanspruchs 1 gelöst.

Insbesondere durch Ausbilden einer Hartmaskenschicht als oberste Schicht eines Trägermaterials, wobei die Hartmaskenschicht beispielsweise eine TEOS-, SiO₂-, Nitrid-, SiC- oder BPSG-Schicht aufweist, kann ein unerwünschtes Dotieren von darunter liegenden Bereichen zuverlässig verhindert werden wodurch die elektrischen Eigenschaften von Halbleiterelementen im Wesentlichen unbeeinflusst bleiben.

Vorzugsweise besteht die Halbleiter-Maskenschicht aus einer amorphen Silizium-Halbleiterschicht, wodurch sich die feinen Strukturen sehr genau ausbilden lassen. Grundsätzlich sind jedoch auch polykristalline oder kristalline Halbleiterschichten für die Halbleiter-Maskenschicht verwendbar.

Eine weitere Verbesserung der Strukturgenauigkeit ergibt sich bei Verwendung von undotiertem oder schwach p-dotiertem Halbleitermaterial für die Halbleiter-Maskenschicht, wobei die Dicke zwischen 10 nm bis 20 nm beträgt.

Bei der sogenannten Belichtung der den Resist ersetzenden Halbleiter-Maskenschicht wird vorzugsweise eine im Wesentlichen senkrecht durchgeführte Ionenimplantation verwendet, wobei man insbesondere in Verbindung mit sehr dünnen Schichten hervorragende Ergebnisse bei der Realisierung von sehr feinen Strukturen erhält. Für die selektive Ionenimplantation kann beispielsweise ein direktes lithographisches Schreiben mit einem fokussierten Ionenstrahl, eine Ionenstrahllithographie mit einer programmierbaren Maske oder eine Ionenstrahllithographie mit einer Projektionsmaske durchgeführt werden. In Abhängigkeit von der gewünschten Struktur können somit jeweils optimierte Belichtungsverfahren bzw. IonenstrahlVerfahren eingesetzt werden. Ferner können auf diese Weise sowohl sehr feine Strukturen in einer Halbleiterschaltung als auch sogenannte Stencil-Masken oder Projektionsmasken mit bisher ungeahnt feinen Strukturen effektiv hergestellt werden. Darüber hinaus können jedoch auch mikromechanische Bauelemente oder ansonsten gewünschte Oberflächeneffekte auf Halbleitermaterialien realisiert werden, wobei die selektive Ionenimplantation zum Dotieren von Halbleiterbereichen und das nasschemische Entfernen der dotierten oder nichtdotierten Halbleiterbereiche unmittelbar in einem Halbleitermaterial bzw. in einem Halbleiterwafer erfolgen kann.

In den Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figuren 1A bis 1E vereinfachte Schnittansichten zur Veranschaulichung wesentlicher Herstellungsschritte eines resistlosen Lithographieverfahrens gemäß einem ersten Ausführungsbeispiel;
Figuren 2A bis 2D vereinfachte Schnittansichten zur Veranschaulichung wesentlicher Herstellungsschritte eines resistlosen Lithographieverfahrens gemäß einem zweiten Ausführungsbeispiel;
Figur 3 eine vereinfachte Schnittansicht zur Veranschaulichung eines wesentlichen Herstellungsschrittes eines resistlosen Lithographieverfahrens gemäß einem dritten Ausführungsbeispiel.

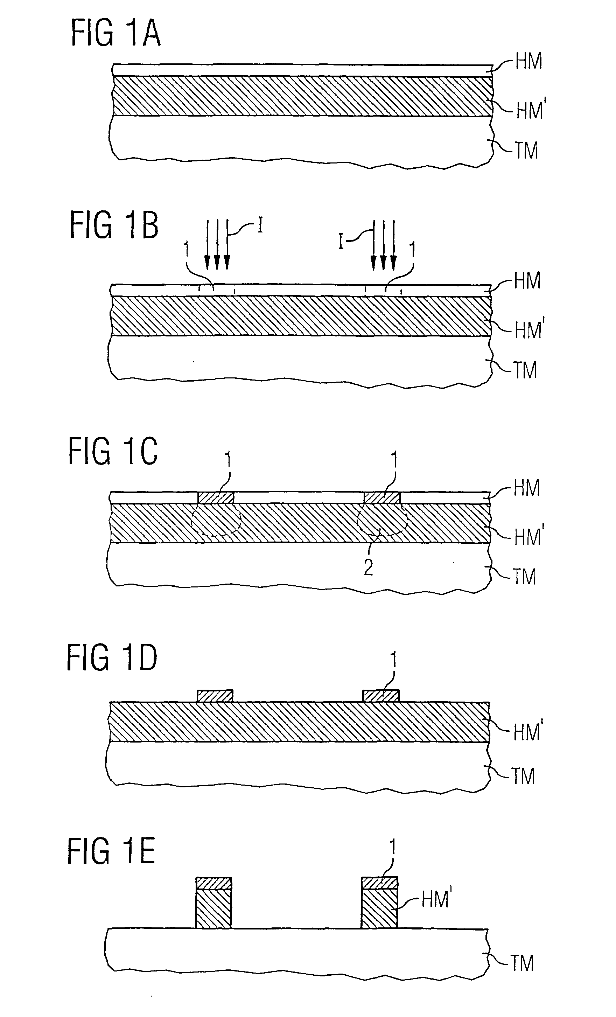

Figuren 1A bis 1E zeigen vereinfachte Schnittansichten von wesentlichen Herstellungsschritten eines resistlosen Lithographieverfahrens gemäß einem ersten Ausführungsbeispiel, wobei gemäß Figur 1A beispielsweise nach einem optionalen Planarisierungsschritt zum Einebnen einer Topologie eines Trägermaterials TM eine dünne Hartmaskenschicht HM' ausgebildet wird. Das Trägermaterial TM stellt beispielsweise einen Si-Wafer bzw. Si-Halbleiterscheibe dar, wobei auch alle weiteren Trägermaterialien und insbesondere Halbleitermaterialien wie beispielsweise III-V-Materialien verwendbar sind.

Als Hartmaskenschicht HM' bzw. oberste Schicht des Trägermaterials wird beispielsweise eine TEOS-, SiO₂-, Nitrid-, SiC- oder BPSG-Schicht ausgebildet. Es können jedoch auch weitere Hartmaskenschichten verwendet werden, die an ein jeweiliges Standardverfahren bzw. ein jeweiliges Trägermaterial TM angepasst sind.

Gemäß Figur 1A wird nunmehr als oberste Schicht eine Halbleiter-Maskenschicht HM auf dem Trägermaterial bzw. der Hartmaskenschicht HM' ausgebildet, wobei vorzugsweise eine dünne amorphe Halbleiterschicht wie z.B. eine Silizium-Halbleiterschicht mit einer Dicke von 10 nm bis 20 nm bei einer Temperatur von 500 bis 600 Grad Celsius abgeschieden wird. Es können jedoch auch andere Verfahren zum Ausbilden der Halbleitermaskenschicht und insbesondere andere Halbleitermaterialien zum Ausbilden dieser Schicht verwendet werden. Obwohl insbesondere eine amorphe Halbleiterschicht als Ersatz für den üblicherweise notwendigen Resist besonders genaue und saubere Strukturen ermöglicht, können bei entsprechend geringeren Anforderungen bzw. Randbedingungen auch polykristalline Halbleiterschichten bzw. kristalline Halbleiterschichten als Halbleiter-Maskenschicht HM ausgebildet werden. In gleicher Weise können auch größere bzw. kleinere Dicken der Halbleiterschicht realisiert werden, wobei jedoch insbesondere in einem sub-100 nm-Bereich derartige Dicken die besten Ergebnisse liefern.

In gleicher Weise wird vorzugsweise undotiertes oder schwach p-dotiertes Halbleitermaterial für die Halbleiter-Maskenschicht HM verwendet, wobei jedoch in gleicher Weise auch n-dotierte Halbleitermaterialien verwendet werden können. Wiederum hat sich jedoch herausgestellt, dass undotierte bzw. schwach p-dotierte Halbleitermaterialien insbesondere bei Verwendung einer amorphen Si-Halbleiter-Maskenschicht die besten Ergebnisse zur Realisierung von sub-100 nm-Strukturen liefern.

Gemäß Figur 1B wird in einem nachfolgenden Verfahrensschritt nunmehr eine selektive Ionenimplantation I zum Dotieren von ausgewählten Bereichen 1 der Halbleiter-Maskenschicht HM durchgeführt. Beispielsweise wird ein fokussierter Ionenstrahl in direkt schreibender Weise auf die amorphe Halbleiter-Maskenschicht HM gerichtet, wobei zur Realisierung einer Dotierstoffkonzentration > 1E19 Atome/cm³ vorzugsweise Bor oder BF₂-Ionen mit entsprechend hohen Energien eingebracht werden. Die Implantationsenergie der selektiven Implantation liegt hierbei in einem Bereich von 1 keV bis 10 keV, wobei eine Implantationsdosis von 1E13 cm⁻² bis SE14cm⁻² verwendet wird. Weiterhin erfolgt die Ionenimplantation I im Wesentlichen senkrecht zu der Halbleiter-Maskenschicht HM, wodurch sich eine besonders exakte Dotierung in dieser Halbleiterschicht HM ergibt und somit Strukturen weit unterhalb von 100 nm Strukturbreite erzeugt werden können. Insbesondere das Zusammenspiel der senkrechten Implantation mit einer geringen Schichtdicke der Halbleiter-Maskenschicht HM und der vorstehend genannten Energien ermöglichen die lithographische Herstellung von bisher nicht erreichten feinen Strukturen.

Vorzugsweise erfolgt die vorstehend beschriebene p-Dotierung in einer undotierten oder schwach p-dotierten Halbleiter-Maskenschicht HM. In gleicher Weise sind jedoch auch n-Dotierungen in einer undotierten oder schwach n-dotierten Halbleiter-Maskenschicht HM oder entgegengesetzte Dotierungen zur Dotierung der Halbleiter-Maskenschicht HM möglich.

Für das vorstehend beschriebene direkte Beschreiben der Halbleiter-Maskenschicht HM sind verschiedene Arten von fokussierten Ionenstrahlverfahren möglich.

Beispielsweise kann in einem sogenannten Single Source - Single Beam-Verfahren mittels einer einzigen Ionenquelle ein einziger Ionenstrahl erzeugt und zum Beschreiben der Halbleiter-Maskenschicht verwendet werden. Weiterhin ist jedoch auch ein sogenanntes Single Source - Multiple Beam-Verfahren möglich, bei dem mittels einer einzigen Ionenquelle eine Vielzahl von Ionenstrahlen erzeugt werden und wiederum die Halbleiter-Maskenschicht damit beschrieben wird. Als eine weitere Alternative für dieses lokale Ionenimplantationsverfahren mit einem fokussierten Strahl kann das sogenannte Multi Source - Single Beam-Verfahren verwendet werden, wobei eine Vielzahl von Ionenquellen zum Erzeugen eines einzelnen Ionenstrahls eingesetzt werden, der wiederum zum parallelen Beschreiben der Halbleiter-Maskenschicht verwendet wird. Ferner kann das sogenannte Multi Source - Multi Beam-Verfahren verwendet werden, bei dem eine Vielzahl von Ionenquellen zur Erzeugung einer Vielzahl von Ionenstrahlen eingesetzt werden, die parallel wiederum die Halbleiter-Maskenschicht HM beschreiben.

Neben den vorstehend beschriebenen fokussierten Ionenstrahlverfahren kann darüber hinaus eine sogenannte Ionenstrahl-Lithographie mit einer programmierbaren Maske durchgeführt werden, wobei beispielsweise eine programmierbare Punktmatrix zum Erzeugen von einzelnen Strahlen verwendet wird, die die Halbleiter-Maskenschicht an jeweiligen Orten belichtet bzw. bestrahlt.

Alternativ zu den vorstehend beschriebenen fokussierten oder nicht fokussierten Ionenstrahl-Lithographieverfahren kann darüber hinaus ein Ionenstrahl-Lithographieverfahren mit einer Projektionsmaske durchgeführt werden, wobei in der Regel ein nicht fokussierter Ionenstrahl durch eine Projektionsmaske auf die Halbleiter-Maskenschicht HM gerichtet ist und durch die Maske lediglich ausgewählte Bereiche dotiert werden.

Die vorstehend beschriebenen Implantationsverfahren können je nach gegebenen Randbedingungen gewählt werden, wodurch man ein sehr flexibles Verfahren erhält.

Figur 1C zeigt eine vereinfachte Schnittansicht eines weiteren Herstellungsschrittes des erfindungsgemäßen resistlosen Lithographieverfahrens, wobei nach dem Implantationsschritt die dotierten Bereiche 1 in der Halbleiter-Maskenschicht HM sowie die dotierten bzw. geschädigten Bereiche 2 in der Hartmaskenschicht HM' dargestellt sind. Gemäß Figur 1C dient demzufolge die Hartmaskenschicht HM' neben ihrer späteren Hartmaskenfunktion auch als Schutzschicht zur Vermeidung einer unbeabsichtigten Dotierung des Trägermaterials TM bzw. einer unbeabsichtigten Störung einer jeweiligen Struktur des Trägermaterials TM durch die Ionenimplantation I. Auf diese Weise können Halbleiterschaltungen mit hervorragenden elektrischen Eigenschaften ausgebildet werden.

Gemäß Figur 1D werden in einem nachfolgenden Schritt mittels eines nasschemischen Ätzverfahrens die nicht-dotierten Bereiche der Halbleiter-Maskenschicht HM zum Ausbilden einer Halbleitermaske entfernt. Vorzugsweise wird hierbei ein Standard-Polysilizium-Nassätzverfahren zum Entfernen der undotierten Bereiche der Halbleiter-Maskenschicht HM mit einer Selektivität > 100 durchgeführt. Beispielsweise kann undotiertes amorphes Silizium mittels Ammoniumhydroxid bzw. NH₄OH mit einer entsprechenden Selektivität entfernt werden. In Abhängigkeit von den verwendeten Materialien bzw. Dotierungen für die Halbleiter-Maskenschicht HM und die Hartmaskenschicht HM' können jedoch auch alternative nasschemische Standard-Ätzverfahren verwendet werden.

In einem abschließenden Schritt wird gemäß Figur 1E unter Verwendung der strukturierten Halbleitermaske bzw. der dotierten Bereiche 1 der Halbleiter-Maskenschicht HM eine Strukturierung der Hartmaskenschicht MM' selektiv zum Trägermaterial TM durchgeführt. Beispielsweise wird hierfür ein anisotropes Trockenätzverfahren zum Übertragen der Halbleitermaske in die Hartmaskenschicht HM' verwendet. Wiederum wird die Ätzchemie in Abhängigkeit von den ausgewählten Materialien für die Halbleitermaske und die darunter liegende Hartmaskenschicht HM' gewählt.

Sollte an Stelle der dünnen Halbleiter-Maskenschicht HM bzw. der dotierten Bereiche 1 eine dünne Oxidmaske benötigt werden, so kann in einem optionalen Schritt der verbleibende dotierte Bereich 1 mittels beispielsweise einer thermischen Oxidation in ein Oxid umgewandelt werden, wobei man insbesondere bei Verwendung von beispielsweise Nitrid als Hartmaskenschicht HM' eine ausreichende Selektivität bei einem Nassätzverfahren erhält. In gleicher Weise können optional die dotierten Bereiche 1 bzw. die in Oxide umgewandelten Bereiche 1 in einem der Figur 1E nachfolgenden Schritt entfernt werden. In gleicher Weise können bei Verwendung entsprechender Ätzchemie auch die nicht-dotierten Bereiche der Halbleiter-Maskenschicht HM entfernt werden, wodurch man eine sogenannte Negativmaske erhält.

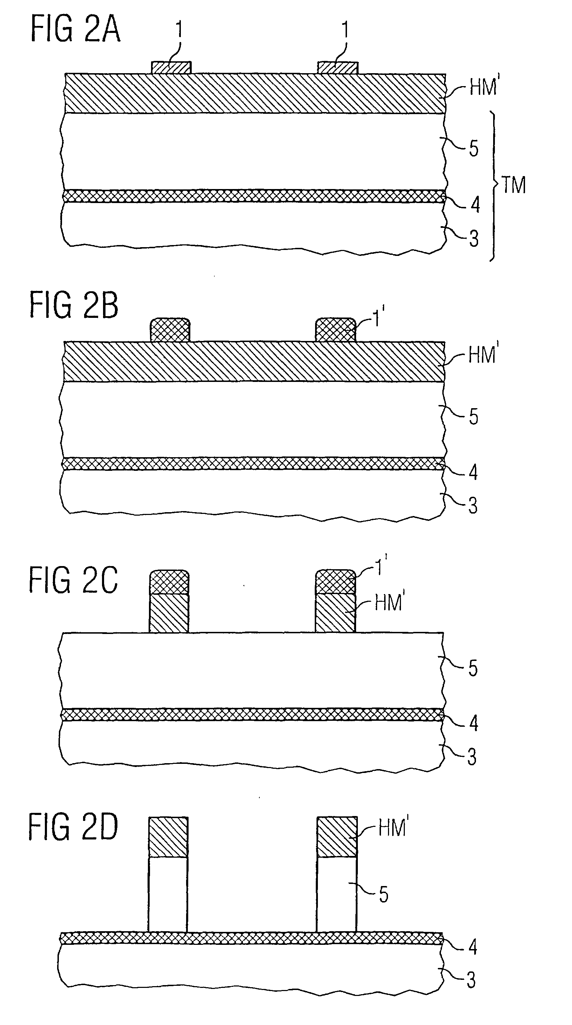

Figuren 2A bis 2D zeigen vereinfachte Schnittansichten von wesentlichen Herstellungsschritten eines resistlosen Lithographieverfahrens gemäß einem zweiten Ausführungsbeispiel, wobei gleiche Bezugszeichen gleiche oder entsprechende Elemente bzw. Schichten bezeichnen und auf eine wiederholte Beschreibung nachfolgend verzichtet wird.

Gemäß diesem zweiten Ausführungsbeispiel wird zur Herstellung eines Gate-Stapels auf einem Halbleiterwafer 3 eine Gateoxidschicht 4 mit einer Dicke von beispielsweise 1-2 nm und eine als Gate bzw. Steuerelektrode dienende Polysiliziumschicht 5 mit einer Dicke von beispielsweise 100 nm ausgebildet. An der Oberfläche der Gate-Schicht 5 befindet sich als Hartmaskenschicht HM' eine ca. 50 nm dicke Nitridschicht. Wiederum wird ähnlich wie in den Figuren 1A bis 1D eine amorphe beispielsweise 15 nm dicke Siliziumschicht ausgebildet und eine selektive Ionenimplantation I zum Dotieren von ausgewählten Bereichen 1 senkrecht durchgeführt. Hierbei werden vorzugsweise Borionen mit einer Energie von etwa 3 keV implantiert. In einem nasschemischen Ätzverfahren werden die nichtimplantierten Bereiche selektiv zur Hartmaskenschicht HM' bzw. zum Nitrid entfernt, wodurch die in Figur 2A dargestellte Schichtstruktur entsteht.

Gemäß Figur 2B kann wiederum optional zur Umwandlung der amorphen Halbleiter-Maskenschicht bzw. der verbliebenen dotierten Bereiche 1 in ein Oxid eine thermische Oxidation bei z.B. 800 Grad Celsius für 10 Minuten durchgeführt werden, wobei sich die Dicke der Oxidschicht l' auf ca. 30 nm verdoppelt.

Anschließend wird gemäß Figur 2C mittels eines anisotropen RIE-Ätzverfahrens (Reaktives Ionenätzen) die Hartmaskenschicht HM' bzw. das Nitrid selektiv zum oxidierten Bereich 1' geätzt, wodurch man eine ausreichend dicke Hartmaskenschicht erhält.

Gemäß Figur 2D wird in einem nachfolgenden Schritt die Oxidmaske bzw. die oxidierten Bereiche 1' entfernt und wiederum ein anisotropes Ätzverfahren wie z.B. reaktives Ionenätzen (RIE) zur Ätzung der Polysiliziumschicht 5 selektiv zur Hartmaskenschicht HM' durchgeführt, wodurch man die in Figur 2D dargestellte Gatestruktur erhält.

Auf diese Weise können in Halbleiterschaltungen beliebig kleine Strukturen frei wählbar, d.h. lithographisch, hergestellt werden, wobei die Strukturen auch sehr nahe beieinander liegen können. Darüber hinaus ermöglicht dieses resistlose Lithographieverfahren ein außerordentlich schnelles und sauberes Strukturieren. Insbesondere bei Verwendung von fokussierten Ionenstrahlen verringert sich eine sogenannte Belichtungszeit und damit die Herstellungszeit der feinen Strukturen mit der sich verringernden Größe der auszubildenden Strukturen. Dieses stellt einen wesentlichen Vorteil zu herkömmlichen Verfahren dar.

Das vorstehend beschriebene Verfahren ist jedoch nicht nur als Lithographieverfahren zur Herstellung von feinen Strukturen in Halbleiterschaltungen verwendbar, sondern auch beispielsweise zur Herstellung von feinen Strukturen in Projektionsmasken bzw. sogenannten Stencil-Masken.

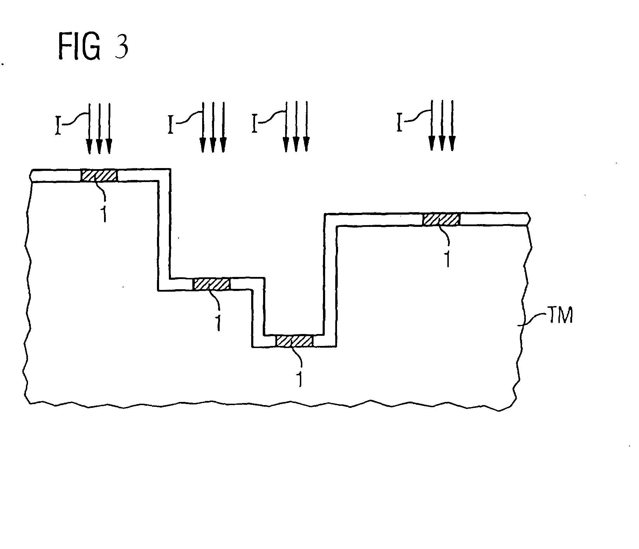

Figur 3 zeigt eine vereinfachte Schnittansicht eines wesentlichen Herstellungsschrittes bei einem resistlosen Lithographieverfahren gemäß einem dritten Ausführungsbeispiel, wobei wiederum gleiche Bezugszeichen gleiche Schichten oder Elemente bezeichnen und auf eine wiederholte Beschreibung dieser Elemente sowie der dazugehörigen Verfahrensschritte nachfolgend verzichtet wird.

Üblicherweise stellen die in Figur 3 dargestellte starken Topographieunterschiede in einem Halbleitermaterial insbesondere für herkömmliche optische Lithographieverfahren große Probleme dar, da eine scharfe Abbildung in den unterschiedlichen Ebenen nicht oder nur sehr schwer möglich ist. Gemäß dem in den Figuren 1 und 2 dargestellten resistlosen Lithographieverfahren können nunmehr auch in unterschiedlichen Ebenen ausgewählte Bereiche 1 sehr exakt dotiert und somit eine außerordentlich genaue Halbleitermaske geschaffen werden.

Die Erfindung wurde vorstehend anhand von Silizium-Halbleiterschichten beschrieben. Sie ist jedoch nicht darauf beschränkt und umfasst in gleicher Weise alternative Materialien. In gleicher Weise können in Halbleiterschaltungen auch andere Strukturen als Gatestrukturen hergestellt werden. Ebenfalls sind neben der Bor- oder BF₂-Implantation und der NH₄OH-Ätzung auch alternative Ionenstrahlen und ebenfalls alternative nasschemische Ätzverfahren möglich.

## Patentansprüche

1. Resistloses Lithographieverfahren zur Herstellung feiner Strukturen in einem Trägermaterial mit den Schritten:
a) Vorbereiten des Trägermaterials (TM, HM'), wobei eine Hartmaskenschicht (HM') als oberste Schicht des Trägermaterials (TM) ausgebildet wird;
b) Ausbilden einer Halbleiter-Maskenschicht (HM) auf der Hartmaskenschicht (HM');
c) Durchführen einer selektiven Ionenimplantation (I) zum Dotieren von ausgewählten Bereichen der Halbleiter-Maskenschicht (HM);
d) Nasschemisches Entfernen der dotierten oder nicht-dotierten Bereiche (1) der Halbleiter-Maskenschicht (HM) zum Ausbilden einer Halbleitermaske;
e) Durchführen einer Strukturierung der Hartmaskenschicht (HM') selektiv zum Trägermaterial (TM) unter Verwendung der strukturierten Halbleitermaske; und
f) Durchführen einer Strukturierung des Trägermaterials (TM) unter Verwendung der strukturierten Hartmaskenschicht (HM').

2. Verfahren nach Patentanspruch 1,
**dadurch gekennzeichnet, dass** als Hartmaskenschicht (HM') eine TEOS-, SiO₂-, Nitrid-, SiC- oder BPSG-Schicht ausgebildet wird.

3. Verfahren nach einem der Patentansprüche 1 oder 2,
**dadurch gekennzeichnet, dass** in Schritt
a) eine Planarisierung des Trägermaterials (HM') durchgeführt wird.

4. Verfahren nach einem der Patentansprüche 1 bis 3,
**dadurch gekennzeichnet, dass** in Schritt
b) eine amorphe, polykristalline oder kristalline Halbleiterschicht ausgebildet wird.

5. Verfahren nach einem der Patentansprüche 1 bis 4,
**dadurch gekennzeichnet, dass** in Schritt
b) eine undotierte oder schwach p-dotierte Halbleiterschicht ausgebildet wird.

6. Verfahren nach einem der Patentansprüche 1 bis 5,
**dadurch gekennzeichnet, dass** in Schritt
b) die Halbleiter-Maskenschicht (HM) mit einer Dicke von 10 nm bis 20 nm ausgebildet wird.

7. Verfahren nach einem der Patentansprüche 1 bis 6,
**dadurch gekennzeichnet, dass** in Schritt
c) die Ionenimplantation (I) im Wesentlichen senkrecht zur Halbleiter-Maskenschicht (HM) erfolgt.

8. Verfahren nach einem der Patentansprüche 1 bis 7,
**dadurch gekennzeichnet, dass** in Schritt
c) ein direktes lithographisches Schreiben mit einem fokussierten Ionenstrahl durchgeführt wird.

9. Verfahren nach Patentanspruch 8,
**dadurch gekennzeichnet, dass**
ein Single Source - Single Beam -Verfahren oder
ein Single Source - Multiple Beam -Verfahren oder
ein Multi Source - Single Beam -Verfahren oder
ein Multi Source - Multi Beam -Verfahren durchgeführt wird.

10. Verfahren nach einem der Patentansprüche 1 bis 7,
**dadurch gekennzeichnet, dass** in Schritt
c) eine Ionenstrahl-Lithographie mit einer programmierbaren Maske durchgeführt wird.

11. Verfahren nach einem der Patentansprüche 1 bis 7,
**dadurch gekennzeichnet, dass** in Schritt
c) eine Ionenstrahl-Lithographie mit einer Projektionsmaske durchgeführt wird.

12. Verfahren nach einem der Patentansprüche 1 bis 11,
**dadurch gekennzeichnet, dass** in Schritt
c) eine Implantationsenergie von 1 keV - 10 keV und eine Implantationsdosis von 1E13 cm⁻² bis 5E14 cm⁻² verwendet wird.

13. Verfahren nach einem der Patentansprüche 1 bis 12,
**dadurch gekennzeichnet, dass** in Schritt
c) eine p-Dotierung mit einer Dotierstoffkonzentration > 1E19 Atome/cm³ durchgeführt wird.

14. Verfahren nach einem der Patentansprüche 1 bis 13,
**dadurch gekennzeichnet, dass** in Schritt
b) undotiertes amorphes Silizium als Halbleiter-Maskenschicht ausgebildet wird und in Schritt
d) ein NH₄OH-Nassätzverfahren zum Entfernen der undotierten Bereiche der Halbleiter-Maskenschicht (HM) mit einer Selektivität > 100 durchgeführt wird.

15. Verfahren nach einem der Patentansprüche 1 bis 14,
**dadurch gekennzeichnet, dass** in Schritt
e) und f) ein anisotropes Ätzverfahren durchgeführt wird.

## Claims

1. Resistless lithography method for fabricating fine structures in a carrier material, having the following steps:
a) preparation of the carrier material (TM, HM'), a hard mask layer (HM') being formed as the topmost layer of the carrier material (TM);
b) formation of a semiconductor mask layer (HM) on the hard mask layer (HM');
c) carrying out of a selective ion implantation (I) for doping selected regions of the semiconductor mask layer (HM);
d) wet-chemical removal of the doped or non-doped regions (1) of the semiconductor mask layer (HM) in order to form a semiconductor mask;
e) carrying out of a patterning of the hard mask layer (HM') selectively with respect to the carrier material (TM) using the patterned semiconductor mask; and
f) carrying out of a patterning of the carrier material (TM) using the patterned hard mask layer (HM').

2. Method according to Patent Claim 1,
**characterized in that** a TEOS, SiO₂, nitride, SiC or BPSG layer is formed as the hard mask layer (HM').

3. Method according to one of Patent Claims 1 and 2,
**characterized in that**, in step a), a planarization of the carrier material (HM') is carried out.

4. Method according to one of Patent Claims 1 to 3,
**characterized in that**, in step b), an amorphous, polycrystalline or crystalline semiconductor layer is formed.

5. Method according to one of Patent Claims 1 to 4,
**characterized in that**, in step b), an undoped or weakly p-doped semiconductor layer is formed.

6. Method according to one of Patent Claims 1 to 5,
**characterized in that**, in step b), the semiconductor mask layer (HM) is formed with a thickness of 10 nm to 20 nm.

7. Method according to one of Patent Claims 1 to 6,
**characterized in that**, in step c), the ion implantation (I) is effected essentially perpendicularly to the semiconductor mask layer (HM).

8. Method according to one of Patent Claims 1 to 7,
**characterized in that**, in step c), a direct lithographic writing with a focused ion beam is carried out.

9. Method according to Patent Claim 9,
**characterized in that**,
a single source - single beam method or a single source - multiple beam method or a multisource - single beam method or a multisource - multibeam method is carried out.

10. Method according to one of Patent Claims 1 to 7,
**characterized in that**, in step c), an ion beam lithography with a programmable mask is carried out.

11. Method according to one of Patent Claims 1 to 7,
**characterized in that**, in step c), an ion beam lithography with a projection mask is carried out.

12. Method according to one of Patent Claims 1 to 11,
**characterized in that**, in step c), an implantation energy of 1 keV - 10 keV and an implantation dose of 1E13 cm⁻² to 5E14 cm⁻² are used.

13. Method according to one of Patent Claims 1 to 12,
**characterized in that**, in step c), a p-type doping with a dopant concentration of > 1E19 atoms/cm³ is carried out.

14. Method according to one of Patent Claims 1 to 13,
**characterized in that**, in step b), undoped amorphous silicon is formed as semiconductor mask layer and, in step d), an NH₄OH wet etching method is carried out for removing the undoped regions of the semiconductor mask layer (HM) with a selectivity of > 100.

15. Method according to one of Patent Claims 1 to 14,
**characterized in that**, in steps e) and f), an anisotropic etching method is carried out.

## Revendications

1. Procédé de lithographie sans résist pour la production de structures fines dans un matériau support comprenant les stades dans lesquels :
a) on prépare le matériau support (TM, HM') en constituant une couche (HM') de masque dur en tant que couche supérieure du matériau support (TM);
b) on constitue une couche (HM) de masque en semi-conducteur sur la couche (HM') de masque dur ;
c) on effectue une implantation (I) sélective d'ions pour doper des parties sélectionnées de la couche (HM) de masque en semi-conducteur ;
d) on élimine en voie chimique humide les parties (1) dopées ou non dopées de la couche (HM) de masque en semi-conducteur pour constituer un masque semi-conducteur ;
e) on effectue une structuration de la couche (HM') de masque dur sélectivement par rapport au matériau support (TM) en utilisant le masque en semi-conducteur structuré ; et
f) on effectue une structuration du matériau support (TM) en utilisant la couche (HM') de masque dur structurée.

2. Procédé suivant la revendication 1, **caractérisé en ce que** l'on constitue comme couche (HM') de masque dur une couche en TEOS, en SiO₂, en nitrure, en SiC ou en BPSG.

3. Procédé suivant l'une des revendications 1 ou 2, **caractérisé en ce qu'**au stade a) on effectue une planarisation du matériau support (HM').

4. Procédé suivant l'une des revendications 1 à 3, **caractérisé en ce qu'**au stade b) on constitue une couche semi-conductrice amorphe, polycristalline ou cristalline.

5. Procédé suivant l'une des revendications 1 à 4, **caractérisé en ce qu'**au stade b) on constitue une couche semi-conductrice non dopée ou à faible dopage du type p.

6. Procédé suivant l'une des revendications 1 à 5, **caractérisé en ce qu'**au stade b) on donne à la couche (HM) de masque en semi-conducteur une épaisseur de 10 nm à 20 nm.

7. Procédé suivant l'une des revendications 1 à 6, **caractérisé en ce qu'**au stade c) on effectue l'implantation (I) d'ions sensiblement perpendiculairement à la couche (HM) de masque en semi-conducteur.

8. Procédé suivant l'une des revendications 1 à 7, **caractérisé en ce qu'**au stade c) on effectue une écriture lithographique directe par un faisceau d'ions focalisé.

9. Procédé suivant la revendication 8, **caractérisé en ce que** l'on effectue un procédé à source unique et à faisceau unique, ou un procédé à source unique et à faisceaux multiples, ou un procédé à sources multiples et à faisceau unique, ou un procédé à sources multiples et à faisceaux multiples.

10. Procédé suivant l'une des revendications 1 à 7, **caractérisé en ce qu'**au stade c) on effectue une lithographie par faisceau d'ions avec un masque programmable.

11. Procédé suivant l'une des revendications 1 à 7, **caractérisé en ce qu'**au stade c) on effectue une lithographie par faisceau d'ions avec un masque de projection.

12. Procédé suivant l'une des revendications 1 à 11, **caractérisé en ce qu'**au stade c) on utilise une énergie d'implantation de 1 keV à 10 keV et une dose d'implantation de 1 E13 cm⁻² à 5E14 cm⁻².

13. Procédé suivant l'une des revendications 1 à 12, **caractérisé en ce qu'**au stade c) on effectue un dopage p avec une concentration de substance de dopage supérieure à 1 E19 atome/cm³.

14. Procédé suivant l'une des revendications 1 à 13, **caractérisé en ce qu'**au stade b) on forme du silicium amorphe non dopé comme couche de masque en semi-conducteur et au stade
d) on effectue un procédé d'attaque en voie humide par NH₄OH pour éliminer les parties non dopées de la couche (HM) de masque en semi-conducteur avec une sélectivité supérieure à 100.

15. Procédé suivant l'une des revendications 1 à 14, **caractérisé en ce qu'**aux stades e) et f) on effectue un procédé d'attaque anisotrope.
